(19) **Europäisches Patentamt European Patent Office Office européen des brevets**

(11) **EP 3 740 405 B1**

(12) **EUROPEAN PATENT SPECIFICATION**

(45) Date of publication and mention of the grant of the patent:
**24.01.2024  Bulletin 2024/04**

(21) Application number: **18811754.3**

(22) Date of filing: **22.11.2018**

(51) International Patent Classification (IPC):
**B60T 17/08** (2006.01)       **B60W 30/00** (2006.01)
**G05B 23/02** (2006.01)       **G06Q 10/00** (2023.01)
**G07C 5/00** (2006.01)

(52) Cooperative Patent Classification (CPC):
**B60T 17/08; B60W 50/04; B60W 50/14;**
**G05B 23/0254;** B60T 17/22; B60W 2510/0638;
B60W 2510/0676; B60W 2510/081;
B60W 2510/087; B60W 2510/107; B60W 2556/50;
G06Q 10/04; G06Q 10/20; G06Q 50/30

(86) International application number:
**PCT/EP2018/082142**

(87) International publication number:
**WO 2019/141411 (25.07.2019 Gazette 2019/30)**

(54) **VEHICLE FAILURE WARNING SYSTEM AND CORRESPONDING VEHICLE FAILURE WARNING METHOD**

AUSFALLWARNSYSTEM UND VERFAHREN FÜR EIN FAHRZEUG

SYSTEME ET METHODE D' ALARME DE DEFAILLANCES POUR UN VEHICULE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **19.01.2018  CN 201810052820**

(43) Date of publication of application:
**25.11.2020  Bulletin 2020/48**

(73) Proprietor: **Robert Bosch GmbH**
**70442 Stuttgart (DE)**

(72) Inventor: **ZANG, Xiaoyun**
**Shanghai 200335 (CN)**

(56) References cited:
**US-A1- 2007 271 014      US-A1- 2016 035 150**
**US-A1- 2016 232 466**

**Description**

**Technical Field**

The present invention relates to a vehicle failure warning system. The present invention further relates to a corresponding vehicle failure warning method.

**Background Art**

With the rapid development of computer and network technologies, the development and application of Internet of Vehicles technology has been greatly promoted. At present, Internet of Vehicles technology can connect vehicles by collecting vehicle information, such as the geographic location, the speed and the road condition, to form a huge interactive network. While in such vehicle networks, on-line monitoring and diagnosis of vehicle failures have been allowed, conventional remote monitoring and diagnosis in the prior art are often retrospective and sluggish.

The word "retrospective" refers to the fact that the remote monitoring and diagnostic means in the prior art generally determine the occurrence of a failure after the vehicle failure has actually occurred and thus only then can diagnose the failure that has occurred and provide maintenance suggestions. This "retrospective" manner often leads to the situation where the condition of the vehicle directly evolves, completely unperceived, from a certain problem, i.e., a "sub-healthy" state, into a vehicle failure, i.e. an "unhealthy" state, due to irreversible damage, which is not only associated with complex and costly diagnostic and maintenance work, but also leaves the user, completely unaware, to drive a "sub-healthy" car that may fail at any time, which not only has the risk of a roadside breakdown but may even be life-threatening.

The word "sluggish" refers to the fact that the prior art remote monitoring and diagnostic system is generally provided by an automotive manufacturer or relevant manufacturers, and such a system tends to be conservative, inclusive and slow in data update, which means that such a remote monitoring and diagnostic system is unable to discover vehicle failures in an agile, instantaneous, reliable and accurate manner.

US 2016/0035150 A1 discloses a model generation server which based on vehicle operational data, vehicle/user data, and vehicle service information generates a model (or models) which predicts the occurrence of errors, vehicle component failures and so on. The model is a trained model and, for example, the predictive models may be trained and/or stored based on the make, model, or year of vehicles. Based on the predicted model, a vehicle analysis and report generation server evaluates vehicle data received from several vehicles to predict the occurrence of certain failure conditions.

US 2007/271014 A1 relates to a vehicle diagnostic and prognostic method and a system for predicting failures in vehicle components. Detected patterns in collected vehicle data are analysed to predict a failure of a component.

US 2016/232466 A1 relates to a method and device for determining risks associated with customer requirements in an organisation. A plurality of user devices are connected to a risk assessment computing device, and based on processing of the user device data a risk analysis is performed.

**Summary of the Invention**

Accordingly, it is an object of the present invention, which is defined by the respective appended independent claims 1 and 6, to provide a "pre-emptive" vehicle failure warning system and vehicle failure warning method capable of accurately and instantaneously predicting an imminent failure in a vehicle prior to the occurrence of the failure, and such a vehicle failure warning system and method enable the relevant personnel to intervene with regard to the possible problems in the vehicle earlier and prior to the occurrence of the failure, and thus not only can the cost and complexity of maintenance be reduced, but also the case where the condition of the vehicle evolves from there being a small problem to a vehicle failure of great danger and trouble is avoided.

The above object is achieved by a vehicle failure warning system, wherein the vehicle failure warning system is in communication connection with a plurality of vehicles and is capable of warning the vehicles of an imminent failure, the vehicle failure warning system comprising:

- a data collection module, the data collection module being configured to collect vehicle data from the plurality of vehicles within a time span to form a data cluster;

- a data screening module, the data screening module being configured to screen data from the data cluster based on characteristics of a failure prediction model to be generated;

- a prediction model generation module, the prediction model generation module being configured to construct the failure prediction model for predicting a vehicle failure, from the data screened by the data screening module using a big-data processing algorithm; and

- a failure prediction module, the failure prediction module being configured to predict, in the situation where the failure prediction model is called and based on real-time vehicle data, whether there is an imminent failure in the vehicle and issue an alert when predicting that there is an imminent failure in the vehicle.

According to a preferred embodiment of the present invention, the failure prediction model is a first type of model which is constructed from data of healthy vehicles and used for describing the operation state of the healthy vehicles; or the failure prediction model is a second type of model which is constructed from data of vehicles where a failure is imminent and which is used for describing the operation state of the vehicles where a failure is imminent.

According to a yet another preferred embodiment of the present invention, the failure prediction model is expressed as a mathematical function between a specific failure parameter and at least one influence parameter for the failure parameter.

According to a further preferred embodiment of the present invention, the failure prediction module is further configured to: substitute, when analyzing whether there is an imminent failure in the vehicle, a real-time measurement value of the at least one influence parameter into the mathematical function so as to calculate an estimated value of the failure parameter; and determine whether there is an imminent failure in the current vehicle by comparing the estimated value of the failure parameter with the real-time measurement value corresponding to the failure parameter.

According to still another preferred embodiment of the present invention, the failure prediction module is further configured to: in the situation where the first type of model is called, if a deviation between the estimated value of the failure parameter and the real-time measurement value corresponding to the failure parameter exceeds a pre-set range, indicate that the failure represented by the failure parameter is imminent in the vehicle; and in the situation where the second type of model is called, if the deviation between the estimated value of the failure parameter and the real-time measurement value corresponding to the failure parameter is within the pre-set range, indicate that the failure represented by the failure parameter is imminent in the vehicle.

The above object is also achieved by a vehicle failure warning method, the method comprising the steps of:

a) collecting vehicle data from a plurality of vehicles within a time span to form a data cluster;
b) screening data from the data cluster based on characteristics of a failure prediction model to be generated;
c) constructing the failure prediction model for predicting a vehicle failure, from the screened data using a big-data processing algorithm;
d) predicting, based on the failure prediction model and real-time vehicle data, whether there is an imminent failure in a vehicle; and
e) issuing an alert when predicting that there is an imminent failure in the vehicle.

According to a preferred embodiment of the present invention, step b) is implemented as follows: the data screened from the data cluster are either data of healthy vehicles, so as to enable the construction of a first type of model for describing the operation state of the healthy vehicles, or data of vehicles where a failure is imminent, so as to enable the construction of a second type of model for describing the operation state of the vehicles where a failure is imminent.

According to yet another preferred embodiment of the present invention, step c) is implemented by: expressing the failure prediction model as a mathematical function between a specific failure parameter and at least one influence parameter for the failure parameter.

According to still another preferred embodiment of the present invention, step d) is implemented by: substituting a real-time measurement value of the at least one influence parameter into the mathematical function so as to calculate an estimated value of the failure parameter, and comparing the estimated value of the failure parameter with the real-time measurement value corresponding to the failure parameter; and in the situation where the first type of model is used, if a deviation between the estimated value of the failure parameter and the real-time measurement value corresponding to the failure parameter exceeds a pre-set range, indicating that the failure represented by the failure parameter is imminent in the vehicle; and in the situation where the second type of model is used, if the deviation between the estimated value of the failure parameter and the real-time measurement value corresponding to the failure parameter is within the pre-set range, indicating that the failure represented by the failure parameter is imminent in the vehicle.

According to a further preferred embodiment of the present invention, the following step is further executed after step c) and before step d): verifying the failure prediction model using vehicle data unused in constructing the failure prediction model, and adjusting the failure prediction model in the case where the verification does not meet requirements.

## Description of The Drawings

The characteristics and advantages of the present invention are further understood by reading the following detailed description of some exemplary preferred embodiments with reference to the accompanying drawings, in which:

Fig. 1 shows a schematic block diagram of a vehicle failure warning system according to the present invention;
Fig. 2 shows a schematic block diagram of an electric drive system for a vehicle according to the present invention;
Fig. 3 shows a schematic structure block diagram of a vehicle failure warning system according to the present invention;
Fig. 4 shows a working flowchart of a vehicle failure warning system according to the present invention;
Fig. 5 shows a flowchart of a first embodiment of a vehicle failure warning method according to the present invention; and
Fig. 6 shows a flowchart of a second embodiment of the vehicle failure warning method according to the present invention.

## Detailed Description

In the present application, identical reference numerals refer to the same or similar components or elements.

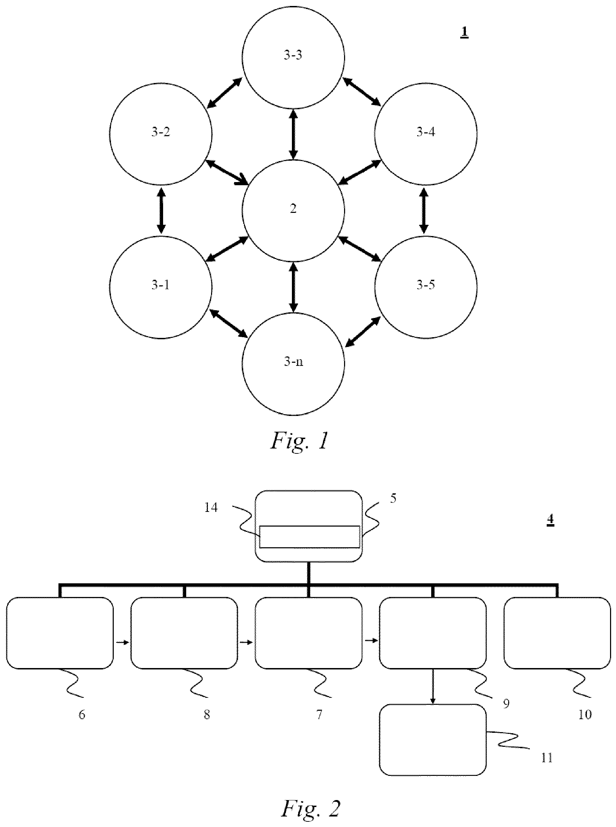

Fig. 1 shows a schematic block diagram of a vehicle failure warning system 1 constructed based on the basic idea of the present invention. As shown in Fig. 1, the vehicle failure warning system according to the present invention comprises a vehicle failure warning system 2 and a plurality of vehicles 3-1, 3-2, ..., and 3-n in communication with the vehicle failure warning system, wherein the plurality of vehicles can also communicate in pairs with each other to perform necessary data transmission.

In one particular embodiment, the vehicle may have no direct communication with the vehicle failure warning system 2, but instead use another vehicle as a relay station to indirectly transmit data to the vehicle failure warning system 2. Moreover, vehicles in communication connection with the same vehicle failure warning system can be any vehicle and are not limited to vehicles having the same identification, such as the same engine model. The type of vehicle is also not limited and can be an electric vehicle, a hybrid vehicle or a conventional fuel-driven vehicle. Hereinafter, the layout and working mode of the vehicle failure warning system 1 according to the present invention will be illustrated in detail by taking an electric drive system as an example.

Thus, the vehicle failure warning system 2 and the plurality of vehicles 3-1, 3-2, ..., and 3-n directly or indirectly in communication connection therewith jointly construct a networked vehicle failure warning system that overcomes geographical and time constraints.

Fig. 2 shows a schematic block diagram of an electric drive system 4 for a vehicle according to the present invention, wherein the electric drive system 4 is an object monitored and warned of by the vehicle failure warning system 2. The electric drive system 4 mainly comprises a battery system 6 having a battery management system (BMS) and a battery assembly, a motor 7 driven by the battery system 6, an inverter 8 located between the battery system 6 and the motor 7, a transmission 9 which transfers a torque produced by the motor 7 to a terminal load 11, for example, a wheel, and comprises a gear assembly and a transmission control unit (TCU), and a control unit 5 for controlling the operation of the electric drive system 4. The control unit 5 comprises a vehicle communication module 14, wherein inside the vehicle, the vehicle communication module communicates with the components of the electric drive system 4, in particular the battery management system, the inverter 8, the motor 7, the transmission control unit, and various sensors 10 (such as wheel speed sensors) provided as needed, so as to collect information from these components. The collected information comprises but is not limited to: the motor speed, the motor temperature, the gearbox temperature, the battery assembly temperature, current and voltage of relevant parts, etc.; and also, outside the vehicle, the vehicle communication module 14 communicates with the above vehicle failure warning system 2 to transmit the collected vehicle data, data generated by its processing, or other data, for example, GPS information, a vehicle ID, an electric drive system ID, etc., to the vehicle failure warning system 2.

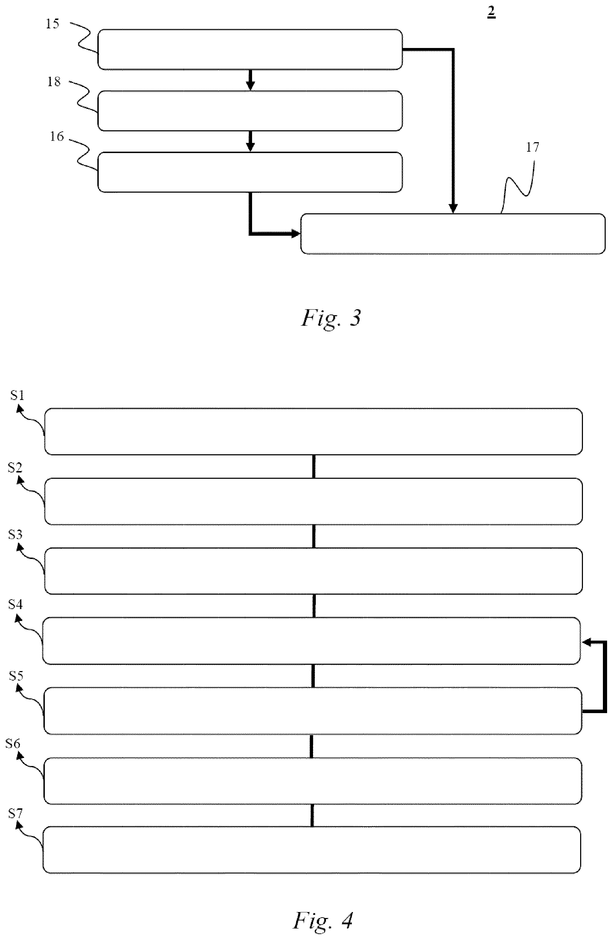

Fig. 3 shows a schematic structure block diagram of the vehicle failure warning system 2 according to the present invention. Before the architecture of the vehicle failure warning system 2 is illustrated in detail in conjunction with Fig. 3, firstly, it is to be explained that the present invention relates to a "pre-emptive" vehicle failure warning system which intends to discover a vehicle failure which is imminent but has not yet occurred and then issue an alert. The feasibility of this technical idea is based on the following fact: a vehicle will undergo a process of development before the condition evolves from a problem with one or some of the components into a failure, the vehicle in the process of development (i.e., in a so-called "sub-healthy" state) exhibits parameters different from those of a "healthy" vehicle, wherein the parameters of the former will evolve over time in a direction that increasingly deviates from the "healthy" parameters. Therefore, such a differentiating and development tendency of the parameters provides the possibility of identifying a "sub-healthy" vehicle and thus achieving a pre-emptive failure warning.

In order to better illustrate this failure evolution process, further explanation is provided taking the overheating of a motor as an example. First of all, there is a problem with a certain component of the motor, such as serious bearing wear, so that the design requirements of the motor cannot be met, and at this time, the motor changes from a "healthy" state to a "sub-healthy" state. However, such a problem itself is difficult to check, and does not cause a motor failure at the beginning. As the degree of the bearing wear increases and the motor continues to operate in a state that does not meet the design requirements, the temperature rise of the motor becomes larger and larger until it exceeds the rated temperature rise and causes a bearing fracture, and at this time, the motor changes from a "sub-healthy" state to an "unhealthy" state. What is achieved by the present invention is to identify such a sub-healthy state that has not yet exhibited overheating but tends to cause overheating, so that an overheat warning can be issued and the relevant personnel can be urged to perform necessary checks and maintenance on the motor in which the problem has occurred and which is about to overheat, thus the overheating and more serious consequences and greater dangers caused by overheating are prevented.

In order to achieve this purpose, the vehicle failure warning system 2 for achieving failure warning according to the present invention comprises a data collection module 15, a prediction model generation module 16 and a failure prediction module 17. The data collection module 15 is configured to collect data from the vehicle communication modules 14 of the vehicles that are in communication connection and provide the collected data to the prediction model generation module 16 and/or the failure prediction module 17. The prediction model generation module 16 is used to generate a failure prediction model for predicting a vehicle failure, using a big-data processing algorithm based on the vehicle data provided by the data collection module 15, and the failure prediction module 17 is used to predict whether there is a failure which is imminent but has not yet occurred in the vehicle, based on real-time vehicle data collected by the data collection module 15 and the failure prediction model generated by the prediction model generation module 16, thereby issuing a warning to the relevant personnel before the failure occurs.

Furthermore, the prediction model generation module 16 is configured to generate a corresponding failure prediction model for different vehicle failures. However, not all vehicle data are relevant to a specific vehicle failure. If vehicle data having little or even no relationship with the specific target failure are transmitted to the prediction model generation module 16, it not only contributes nothing to the establishment of the model but rather increases the calculation cost. To this end, according to the present invention, before the data collection module 15 transmits the data to the prediction model generation module 16, the data need to be first screened and filtered. Such screening and filtering can be executed by a data screening module 18 additionally provided in the vehicle failure warning system 2, wherein the data screening module 18 can be provided independently of the modules 15, 16 and 17, for example, connected between the data collection module 15 and the prediction model generation module 16 as shown in Fig. 3, or can be integrated as a sub-module in any one of these modules 15-17.

According to one particular embodiment of the invention, the prediction model generation module 16 is configured to establish a failure prediction model based on data of healthy vehicles. The failure prediction model thus established is actually a model describing the operation state of a healthy vehicle. That is, it describes what operation states and operation parameters should be exhibited by a healthy vehicle.

In this case, in order to ensure that the failure prediction model is established based on pure healthy data, unhealthy data must be filtered out from the data provided by the data collection module 15 to the prediction model generation module 16. In this regard, for example, the data collection module 15 can continuously collect vehicle data from vehicles within a time span until the data need to be provided to the prediction model generation module 16, and at this time the data collection module 15 transmits all the data to the data screening module 18, and the data screening module 18 then deletes the data produced by vehicles in which failures have occurred and then provides the data remaining after deletion to the prediction model generation module 16.

According to a further particular embodiment of the invention, the prediction model generation module 16 is configured to establish a failure prediction model based on data of sub-healthy vehicles. In this case, the failure prediction model is actually a model describing the operation state of a vehicle that has experienced a problem which however has not evolved into a failure. That is to say, it describes what operation states and operation parameters should be exhibited by a "sub-healthy" vehicle in which a failure is imminent. To this end, the data screening module 18 screens data, which are produced in the sub-healthy phase by the vehicle in which a failure has occurred, from the data collected by the data collection module 15 and provides the screened sub-healthy data to the prediction model generation module 16.

In other words, the data screening module 18 is configured to filter and screen the data collected by the data collection module 15 based on the characteristics of the failure prediction model to be established by the prediction model generation module 16, so as to ensure that only the data related to the failure prediction model to be established are provided to the prediction model generation module 16.

In addition, the big-data processing algorithm used by the prediction model generation module 16 to establish the failure prediction model is, for example, a general algorithm or a neural network algorithm, which can be known from the prior art, and will not be further described herein. Moreover, the target failure targeted by the prediction model generation module 16 should be characterized as a measurable physical parameter such as the motor temperature and the inverter temperature, or other physical parameters such as current and voltage.

In one particular embodiment, the failure prediction model established by the prediction model generation module 16 by means of big data analyses is expressed as a mathematical function between the target failure parameter and influence parameters therefor. For example, a prediction model for the failure of motor winding overheating is expressed as the following mathematical function:

$$T(t_0,t_1,\ldots t_n)=FCN(N(t_0,t_1,\ldots t_n),I(t_0,t_1,\ldots t_n),V(t_0,t_1,\ldots t_n),TO(t_0,t_1,\ldots t_n)) \quad (1)$$

where T denotes the motor winding temperature, n represents the nth sampling during the driving time, $t_n$ represents the time point of the nth sampling, and FCN denotes a model function for predicting the motor winding temperature T from the influence parameters N, I, V and TO, wherein the influence parameter N denotes the motor speed, the influence parameter I denotes the motor current, the influence parameter V denotes the battery voltage, and the influence parameter TO denotes the motor torque. These influence parameters are selected based on physical analyses of the electric drive system.

Fig. 4 shows a working flowchart of the vehicle failure warning system 1 according to the present invention. The working mode of the vehicle failure warning system 1 will be illustrated below in conjunction with Fig. 4.

As shown in Fig. 4, firstly, in step S1, the control unit 5 of each of the plurality of vehicles in communication connection with the vehicle failure warning system 2 collects data of the vehicle in real time and transmits same to the data collection module 15 of the vehicle failure warning system 2 in real time.

Then, in step S2, the data collection module 15 continuously collects the vehicle data within a time span to form a data cluster, wherein the data cluster serves as the basis for constructing a failure prediction model.

Then, in step S3, according to the object and characteristics of the failure prediction model to be generated by the prediction model generation module 16, the data cluster is filtered and screened by the data screening module 18 and then provided to the prediction model generation module 16; and

next, in step S4, in the prediction model generation module 16, the failure prediction model is constructed using the big-data processing algorithm based on the provided data.

Then, in step S5, the established failure prediction model is verified using vehicle data unused in constructing the failure prediction model. If the verification meets requirements, the next step is proceeded to in the flow; and if the verification does not meet requirements, the failure prediction model is adjusted until the verification reaches the standard.

Then, in step S6, after constructing the compliant failure prediction model, the failure prediction module 17 receives the real-time vehicle data received from the vehicle by the data collection module 15, and also calls the failure prediction model generated by the prediction model generation module 16, and analyzes whether there is an imminent failure in the vehicle according to the real-time vehicle data and the failure prediction model.

Finally, in step S7, when determining that there is an imminent failure in the vehicle, the failure prediction module 17 issues a warning to the relevant personnel, such as the driver or the monitoring personnel, and gives relevant suggestions.

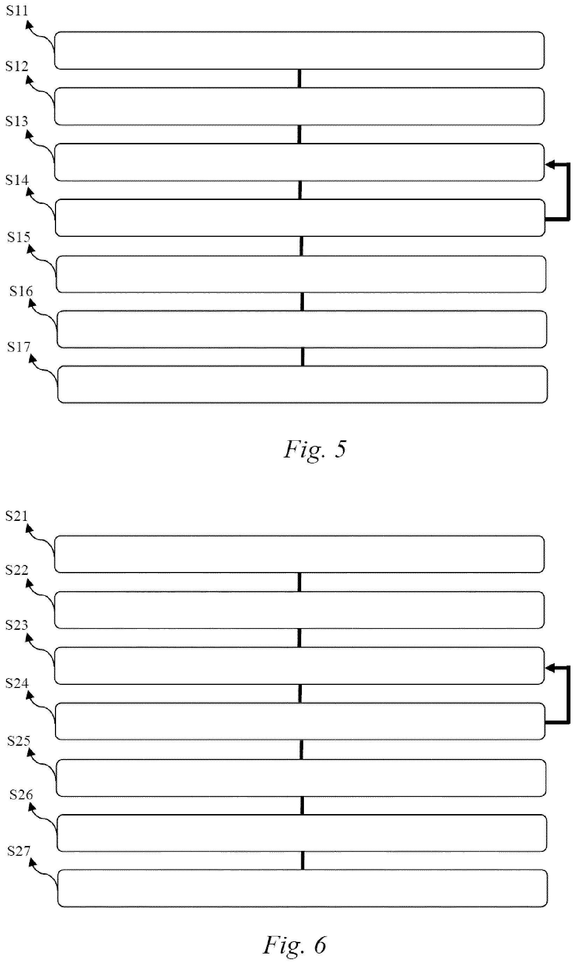

Fig. 4 macroscopically illustrates a vehicle failure warning method implemented by the vehicle failure warning system 1 according to the present invention, and Figs. 5 and 6 respectively illustrate two specific embodiments of such a vehicle failure warning method. Both of the embodiments are based on motor overheating as a target failure, with the key difference therebetween lying in the fact that the failure warning models constructed are different.

In the first embodiment of the vehicle failure warning method according to the present invention shown in Fig. 5: First of all, in step S11, the data collection module 15 is enabled to collect vehicle data from a plurality of vehicles in communication connection with the vehicle failure warning system 2 within a time span to form a data cluster, wherein the data cluster serves as the basis for constructing a model for predicting motor winding overheating.

Then, in step S12, the data screening module 18 screens data of healthy vehicles associated with motor winding overheating from the data cluster and provides same to the prediction model generation module 16, wherein, vehicle data associated with motor winding overheating may be selected based on physical reasons for motor winding overheating, such as the motor speed, the motor current, the battery voltage and the motor torque. Moreover, the data screening module 18 also ensures that all of the screened data are data of healthy vehicles, which can be achieved by filtering out data produced by vehicles in which failures have occurred within the time span, even up to the time of data screening.

Then, in step S13, a first type of prediction model for predicting motor winding overheating is constructed from the provided data using a big-data processing algorithm in the prediction model generation module 16, wherein the first type of prediction model may be expressed as, for example, a mathematical function of which the form can be similar to that of the mathematical function (1) mentioned above.

Next, in step S14, the prediction model is verified using vehicle data unused in constructing the first type of prediction model. Similar to the above step S5, the prediction model is adjusted if the verification does not meet the requirements, until the verification is reached.

Then, in step S15, the failure prediction module 17 receives the latest vehicle data from the data collection module 15 in real time, and also calls the prediction model for motor winding overheating constructed in step S13, and analyzes, based on the two, whether there is imminent motor winding overheating in the vehicle. The specific analysis method is as follows: substituting the real-time motor speed value, the real-time motor current value, the real-time battery voltage value, and the real-time motor torque value into the mathematical function constructed in step S13 to calculate the estimated motor winding temperature value, wherein the estimated motor winding temperature value has the following meaning: it refers to what motor winding temperature value a healthy electric drive system should have with such a motor speed value, motor current value, battery voltage value and motor torque value. This estimated motor winding temperature value is extrapolated based on a large amount of data of healthy electric drive systems. It indicates, in a situation where a large number of healthy electric drive systems once appeared, what motor winding temperature value is exhibited when the healthy electric drive systems exhibit such a motor speed value, motor current value, battery voltage value and motor torque value.

Then, in step S16, the estimated motor winding temperature value is compared to the corresponding real-time motor winding temperature measurement value. If a deviation between the corresponding real-time motor winding temperature measurement value and the estimated motor winding temperature value is within a pre-set range, it indicates that the current operation state of the electric drive system is no different from that of a healthy electric drive system; thus the current electric drive system is healthy and normal, and there is no imminent motor winding overheating; and conversely, if the corresponding real-time motor winding temperature measurement value is higher than the estimated motor winding temperature value by a deviation exceeding the pre-set range, it indicates that there are certain failures in the electric drive system and there is imminent motor winding overheating.

Thus, in the subsequent step S17, an alert is issued to the relevant personnel and relevant suggestions are provided when it is predicted that the motor winding is about to overheat.

The following technical effect is achieved according to this embodiment of the invention: the relevant personnel can learn that the motor is possibly about to overheat before the motor overheats to such an extent as to cause other more serious problems, so that the problematic electric drive system can be intervened with earlier, and thus not only can maintenance costs be saved on, but more importantly, more serious dangers, even life-threatening dangers, can be prevented from occurring.

In one particular embodiment, the verification of the prediction model in the above step S14 can be specifically implemented as follows: at least one set of unused vehicle data are substituted into the mathematical function so as to calculate a corresponding motor winding temperature value, and then the calculated motor winding temperature value is compared with a corresponding real-time motor winding temperature measurement value; and if the deviation between the two exceeds a pre-set range, it indicates that the current failure prediction model is not accurate enough and needs further adjustment.

In the second embodiment of the vehicle failure warning method according to the present invention shown in Fig. 6:

Firstly, in step S21, similar to step S11, the data collection module 15 is enabled to collect vehicle data from a plurality of vehicles within a time span to form a data cluster for modelling.

Then, in step S22, the data screening module 18 screens data of sub-healthy vehicles associated with motor overheating from the data cluster and provides the screened data to the prediction model generation module 16. For the understanding of the screening condition "associated with motor overheating", reference can be made to the above step S12. For the screening condition "sub-healthy", the data are required to meet the following two requirements at the same time: firstly, the data must be data of electric drive systems with motor overheating, and secondly, the data must be data within the period of time from the start of motor temperature rise to the occurrence of motor overheating.

Next, in step S23, similar to step S13, a second type of prediction model for predicting motor overheating is constructed from the provided data using a big-data processing algorithm in the prediction model generation module 16, wherein the prediction model may be expressed as, for example, a mathematical function, and the form of the mathematical function can be similar to the above mathematical function (1), but the function content is different from that of the first type of failure prediction function constructed in the above first embodiment. Since the second type of failure prediction model is established based on a large amount of data of sub-healthy vehicles, i.e., vehicle data shortly before motor overheating, this prediction model describes the state exhibited by the vehicle in which there is imminent motor overheating.

Then, in step S24, the model is verified using the vehicle data unused in constructing the failure prediction model; the model is adjusted if the verification does not meet the requirements until the verification is reached, which is similar to the above steps S5 and S14; and

then, in step S25, the failure prediction module 17 receives the latest vehicle data from the data collection module 15 in real time, and also calls the prediction model for motor overheating constructed in step S23, and analyzes, based on the two, whether there is imminent motor overheating in the vehicle. The specific analysis method is as follows: substituting the real-time motor speed value, the real-time motor current value, the real-time battery voltage value and the real-time motor torque value into the mathematical function constructed in step S23 to calculate the estimated motor temperature value, wherein the estimated motor temperature value has the following meaning: it indicates that, in the case of exhibiting such a motor speed value, motor current value, battery voltage value and motor torque value, a sub-healthy electric drive system with certain problems that may cause motor overheating would exhibit such a motor temperature value. This estimated motor temperature value is extrapolated and obtained based on a large amount of data of sub-healthy electric drive systems. It indicates, in a situation where a large number of sub-healthy electric drive systems once appeared, what motor temperature value is exhibited when the healthy electric drive systems exhibit such a motor speed value, motor current value, battery voltage value and motor torque value.

Then, in step S26, the estimated motor temperature value is compared to the corresponding real-time motor temperature measurement value. If the corresponding real-time motor temperature measurement value is significantly different from the estimated motor temperature value, it indicates that the current operation state of the electric drive system is significantly different from that of a sub-healthy electric drive system, and thus it can be determined that the current electric drive system is healthy and normal, and there is no imminent motor overheating. Conversely, if the corresponding real-time motor temperature measurement value is approximate to or the same as the estimated motor temperature value, for example, the deviation between the two is within a pre-set range, it indicates that the operation state of the current electric drive system is similar to that of the operation state of a sub-healthy electric drive system that appeared before, and thus it is very likely that the motor overheating is about to occur as it did in the sub-healthy electric drive systems in history. In this case, then, in the subsequent step S27, an overheating warning is issued to the relevant personnel and relevant suggestions are provided.

Of course, the idea of the present invention is not limited to the single failure of motor overheating, but is also applicable to any other vehicle failure, such as battery pack failure and gearbox failure.

In addition, it is to be illustrated that the prediction model generation module 16 according to the present invention can also simultaneously construct both of the above-mentioned first type of failure prediction model and the above-mentioned second type of failure prediction model, so that the failure prediction module 17 can call the two types of models together to perform failure warning analyses, and issue a failure warning when both types of models indicate that there is an imminent failure in the current vehicle. This reduces the risk of false alarm and increases the credibility of failure warnings.

Although some embodiments have been illustrated, these embodiments are presented by way of example only and are not intended to limit the scope of the invention.

## Claims

1. Vehicle failure warning system (2), wherein the vehicle failure warning system (2) is in communication connection with a plurality of vehicles (3-1, 3-2...3-n) and is capable of warning a vehicle of an imminent failure, the vehicle failure warning system (2) comprising:

   a) a data collection module (15), the data collection module (15) being configured to collect vehicle data from the plurality of vehicles (3-1, 3-2...3-n) within a time span to form a data cluster; **characterized in that** said vehicle failure warning system (2) further comprises :
   b) a data screening module (18), the data screening module (18) being configured to screen data from the data cluster based on characteristics of a failure prediction model to be generated;
   c) a prediction model generation module (16), the prediction model generation module (16) being configured to construct the failure prediction model for predicting a vehicle failure, from the data screened by the data screening module (18); and
   d) a failure prediction module (17), the failure prediction module (17) being configured to predict, in the situation where the failure prediction model is called and based on real-time vehicle data, whether there is an imminent failure in the vehicle and issue an alert when predicting that there is an imminent failure in the vehicle.

2. Vehicle failure warning system (2) according to Claim 1, **characterized in that**
   the constructed failure prediction model is a first type of model and/or a second type of model, wherein the first type of model is a failure prediction model which is constructed based on data of healthy vehicles and which is used for describing the operation state of the healthy vehicles, while the second type of model is a failure prediction model which is constructed based on data of vehicles where a failure is imminent and which is used for describing the operation state of the vehicles where a failure is imminent.

3. Vehicle failure warning system (2) according to Claim 1 or 2, **characterized in that**

the failure prediction model is expressed as a mathematical function between a specific failure parameter and at least one influence parameter for the failure parameter, wherein the specific failure parameter refers to a parameter characterizing a specific vehicle failure; and/or
the prediction model generation module (16) is configured to construct the failure prediction model from the screened data using a big-data processing algorithm.

4. Vehicle failure warning system (2) according to Claim 3, **characterized in that**
the failure prediction module (17) is further configured to: substitute, when predicting whether there is an imminent failure in the vehicle, a real-time measurement value of the at least one influence parameter into the mathematical function so as to calculate an estimated value of the failure parameter; and determine whether there is an imminent failure in the current vehicle by comparing the estimated value of the failure parameter with the real-time measurement value corresponding to the failure parameter.

5. Vehicle failure warning system (2) according to Claim 4, **characterized in that**
the failure prediction module (17) is further configured to: in the situation where the first type of model is called, if a deviation between the estimated value of the failure parameter and the real-time measurement value corresponding to the failure parameter exceeds a pre-set range, indicate that the failure **characterized by** the failure parameter is imminent in the vehicle; and in the situation where the second type of model is called, if the deviation between the estimated value of the failure parameter and the real-time measurement value corresponding to the failure parameter is within the pre-set range, indicate that the failure **characterized by** the failure parameter is imminent in the vehicle.

6. Vehicle failure warning method, the method comprising the steps of:

a) collecting (S1; S11) vehicle data from a plurality of vehicles (3-1, 3-2...3-n) within a time span to form a data cluster; **characterized by :**
b) screening (S3; S12) data from the data cluster based on characteristics of a failure prediction model to be generated;
c) constructing (S4), from the screened data, the failure prediction model for predicting a vehicle failure;
d) predicting (S6), based on the failure prediction model and real-time vehicle data, whether there is an imminent failure in a vehicle; and
e) issuing (S7) an alert when predicting that there is an imminent failure in the vehicle.

7. Vehicle failure warning method according to Claim 6, **characterized in that** steps b) and c) are implemented by:

in step b), screening data of healthy vehicles from the data cluster, and then in step c), constructing a first type of model for describing the operation state of the healthy vehicles; and/or
in step b), screening data of vehicles in which a failure is imminent from the data cluster, and then in step c), constructing a second type of model for describing the operation state of the vehicles in which a failure is imminent.

8. Vehicle failure warning method according to Claim 6 or 7, **characterized in that** step c) is implemented by:
expressing the failure prediction model as a mathematical function between a specific failure parameter and at least one influence parameter for the failure parameter, wherein the specific failure parameter refers to a parameter characterizing a specific vehicle failure; and/or constructing the failure prediction model from the screened data using a big-data processing algorithm.

9. Vehicle failure warning method according to Claim 8, **characterized in that** step d) is implemented by:

substituting a real-time measurement value of the at least one influence parameter into the mathematical function so as to calculate an estimated value of the failure parameter, and comparing the estimated value of the failure parameter with the real-time measurement value corresponding to the failure parameter;
and in the situation where the first type of model is used, if a deviation between the estimated value of the failure parameter and the real-time measurement value corresponding to the failure parameter exceeds a pre-set range, indicating that the failure **characterized by** the failure parameter is imminent in the vehicle; and in the situation where the second type of model is used, if the deviation between the estimated value of the failure parameter and

the real-time measurement value corresponding to the failure parameter is within the pre-set range, indicating that the failure **characterized by** the failure parameter is imminent in the vehicle.

**10.** Vehicle failure warning method according to any one of Claims 6-9, **characterized in that** the following step is further executed after step c) and before step d):
verifying the failure prediction model using vehicle data unused in constructing the failure prediction model, and adjusting the failure prediction model in the case where the verification does not meet requirements.

**Patentansprüche**

**1.** Fahrzeugausfallwarnsystem (2), wobei das Fahrzeugausfallwarnsystem (2) in Kommunikationsverbindung mit einer Mehrzahl von Fahrzeugen (3-1, 3-2... 3-n) steht und in der Lage ist, ein Fahrzeug vor einem unmittelbar bevorstehenden Ausfall zu warnen, wobei das Fahrzeugausfallwarnsystem (2) umfasst:

a) ein Datensammelmodul (15), wobei das Datensammelmodul (15) dazu ausgelegt ist, Fahrzeugdaten von der Mehrzahl von Fahrzeugen (3-1, 3-2... 3-n) innerhalb einer Zeitspanne zu sammeln, um einen Datencluster zu bilden; **dadurch gekennzeichnet, dass** das Fahrzeugausfallwarnsystem (2) ferner umfasst:
b) ein Daten-Screening-Modul (18), wobei das Daten-Screening-Modul (18) dazu ausgelegt ist, Daten von dem Daten-Cluster basierend auf Eigenschaften eines zu erzeugenden Ausfallvorhersagemodells zu screenen;
c) ein Vorhersagemodell-Erzeugungsmodul (16), wobei das Vorhersagemodell-Erzeugungsmodul (16) dazu ausgelegt ist, das Ausfallvorhersagemodell zum Vorhersagen eines Fahrzeugausfalls aus den durch das Daten-Screening-Modul (18) gescreenten Daten zu erstellen; und
d) ein Ausfallvorhersagemodul (17), wobei das Ausfallvorhersagemodul (17) dazu ausgelegt ist, in der Situation, in der das Ausfallvorhersagemodell aufgerufen wird, und basierend auf Echtzeit-Fahrzeugdaten vorherzusagen, ob ein unmittelbar bevorstehender Ausfall im Fahrzeug vorliegt, und eine Warnung auszugeben, wenn vorhergesagt wird, dass ein unmittelbar bevorstehender Ausfall im Fahrzeug vorliegt.

**2.** Fahrzeugausfallwarnsystem (2) nach Anspruch 1, **dadurch gekennzeichnet, dass**
das erstellte Ausfallvorhersagemodell eine erste Art von Modell und/oder eine zweite Art von Modell ist, wobei die erst Art von Modell ein Ausfallvorhersagemodell ist, das basierend auf Daten intakter Fahrzeuge erstellt ist und zum Beschreiben des Betriebszustands der intakten Fahrzeuge verwendet wird, während die zweite Art von Modell ein Ausfallvorhersagemodell ist, das basierend auf Daten von Fahrzeugen aufgebaut ist, bei denen ein Ausfall unmittelbar bevorsteht, und das zur Beschreibung des Betriebszustands der Fahrzeuge verwendet wird, bei denen ein Ausfall unmittelbar bevorsteht.

**3.** Fahrzeugausfallwarnsystem (2) nach Anspruch 1 oder 2, **dadurch gekennzeichnet, dass**

das Ausfallvorhersagemodell als eine mathematische Funktion zwischen einem spezifischen Ausfallparameter und mindestens einem Einflussparameter für den Ausfallparameter ausgedrückt wird, wobei sich der spezifische Ausfallparameter auf einen Parameter bezieht, der einen spezifischen Fahrzeugausfall kennzeichnet; und/oder das Vorhersagemodell-Erzeugungsmodul (16) dazu ausgelegt ist, das Ausfallvorhersagemodell aus den gescreenten Daten unter Verwendung eines Big-Data-Verarbeitungsalgorithmus zu erstellen.

**4.** Fahrzeugausfallwarnsystem (2) nach Anspruch 3, **dadurch gekennzeichnet, dass**
das Ausfallvorhersagemodul (17) ist ferner dazu ausgelegt, beim Vorhersagen, ob ein unmittelbar bevorstehender Ausfall in dem Fahrzeug vorliegt, einen Echtzeit-Messwert des mindestens einen Einflussparameters in die mathematische Funktion zu ersetzen, um einen geschätzten Wert des Ausfallparameters zu berechnen; und zu bestimmen, ob ein unmittelbar bevorstehender Ausfall in dem aktuellen Fahrzeug vorliegt, indem der geschätzte Wert des Ausfallparameters mit dem Echtzeitmesswert, der dem Ausfallparameter entspricht, verglichen wird.

**5.** Fahrzeugausfallwarnsystem (2) nach Anspruch 4, **dadurch gekennzeichnet, dass**
das Ausfallvorhersagemodul (17) ferner dazu ausgelegt ist, in der Situation, in der die erste Art von Modell aufgerufen wird, wenn eine Abweichung zwischen dem geschätzten Wert des Ausfallparameters und dem Echtzeitmesswert, der dem Ausfallparameter entspricht, einen voreingestellten Bereich überschreitet, anzuzeigen, dass der durch den Ausfallparameter gekennzeichnete Ausfall in dem Fahrzeug unmittelbar bevorsteht; und in der Situation, in der die zweite Art von Modell aufgerufen wird, wenn die Abweichung zwischen dem geschätzten Wert des Ausfallparameters und dem Echtzeitmesswert, der dem Ausfallparameter entspricht, innerhalb des voreingestellten Bereichs liegt, anzuzeigen, dass der durch den Ausfallparameter gekennzeichnete Ausfall in dem Fahrzeug unmittelbar bevorsteht.

6. Fahrzeugausfallwarnverfahren, wobei das Verfahren die folgenden Schritte umfasst:

   a) Sammeln (S1; S11) von Fahrzeugdaten von einer Mehrzahl von Fahrzeugen (3-1, 3-2... 3-n) innerhalb einer Zeitspanne, um einen Datencluster zu bilden; **gekennzeichnet durch**:
   b) Screening (S3; S12) von Daten aus dem Datencluster basierend auf Eigenschaften eines zu erzeugenden Ausfallvorhersagemodells;
   c) Erstellen (S4) des Ausfallvorhersagemodells zum Vorhersagen eines Fahrzeugausfalls aus den gescreenten Daten;
   d) Vorhersagen (S6), basierend auf dem Ausfallvorhersagemodell und Echtzeit-Fahrzeugdaten, ob ein unmittelbar bevorstehender Ausfall in einem Fahrzeug vorliegt; und
   e) Ausgeben (S7) einer Warnung, wenn vorhergesagt wird, dass ein unmittelbar bevorstehender Ausfall im Fahrzeug vorliegt.

7. Fahrzeugausfallwarnverfahren nach Anspruch 6, **dadurch gekennzeichnet, dass** die Schritte b) und c) implementiert werden durch:
   in Schritt b) Screenen von Daten intakter Fahrzeuge von dem Datencluster und dann in Schritt c) Erstellen einer ersten Art von Modell zum Beschreiben des Betriebszustands der intakten Fahrzeuge; und/oder in Schritt b) Screenen von Daten von Fahrzeuge in denen ein Ausfall unmittelbar bevorsteht von dem Datencluster und dann in Schritt c) Erstellen einer zweiten Art von Modell zum Beschreiben des Betriebszustands der Fahrzeuge, in denen ein Ausfall unmittelbar bevorsteht.

8. Fahrzeugausfallwarnverfahren nach Anspruch 6 oder 7, **dadurch gekennzeichnet, dass** Schritt c) implementiert wird durch:
   Ausdrücken des Ausfallvorhersagemodells als mathematische Funktion zwischen einem spezifischen Ausfallparameter und mindestens einem Einflussparameter für den Ausfallparameter, wobei sich der spezifische Ausfallparameter auf einen Parameter bezieht, der einen spezifischen Fahrzeugausfall kennzeichnet; und/oder Erstellen des Ausfallvorhersagemodells aus den gescreenten Daten unter Verwendung eines Big-Data-Verarbeitungsalgorithmus.

9. Fahrzeugausfallwarnverfahren nach Anspruch 8, **dadurch gekennzeichnet, dass** Schritt d) implementiert wird durch:

   Ersetzen eines Echtzeit-Messwerts des mindestens einen Einflussparameters in die mathematische Funktion, um einen geschätzten Wert des Ausfallparameters zu berechnen, und Vergleichen des geschätzten Werts des Ausfallparameters mit dem Echtzeit-Messwert, der dem Ausfallparameter entspricht;
   und in der Situation, in der die erste Art von Modell verwendet wird, wenn eine Abweichung zwischen dem geschätzten Wert des Ausfallparameters und dem Echtzeitmesswert, der dem Ausfallparameter entspricht, einen voreingestellten Bereich überschreitet, Angeben, dass der durch den Ausfallparameter gekennzeichnete Ausfall in dem Fahrzeug unmittelbar bevorsteht; und in der Situation, in der die zweite Art von Modell verwendet wird, wenn die Abweichung zwischen dem geschätzten Wert des Ausfallparameters und dem Echtzeitmesswert, der dem Ausfallparameter entspricht, innerhalb des voreingestellten Bereichs liegt, Angeben, dass der durch den Ausfallparameter gekennzeichnete Ausfall in dem Fahrzeug unmittelbar bevorsteht.

10. Fahrzeugausfallwarnverfahren nach einem der Ansprüche 6-9, **dadurch gekennzeichnet, dass** der folgende Schritt ferner nach Schritt c) und vor Schritt d) ausgeführt wird:

    Verifizieren des Ausfallvorhersagemodells unter Verwendung von Fahrzeugdaten, die beim Erstellen des Ausfallvorhersagemodells nicht verwendet wurden, und
    Anpassen des Ausfallvorhersagemodells in dem Fall, dass die Verifizierung die Anforderungen nicht erfüllt.

**Revendications**

1. Système d'avertissement de défaillance de véhicule (2), dans lequel le système d'avertissement de défaillance de véhicule (2) est en connexion de communication avec une pluralité de véhicules (3-1, 3-2...3-n) et est capable d'avertir un véhicule d'une défaillance imminente, le système d'avertissement de défaillance de véhicule (2) comprenant :

a) un module de collecte de données (15), le module de collecte de données (15) étant configuré pour collecter les données de véhicule de la pluralité de véhicules (3-1, 3-2...3-n) dans un certain laps de temps pour former un groupe de données ; **caractérisé en ce que** ledit système d'avertissement de défaillance de véhicule (2) comprend en outre :
b) un module de tri de données (18), le module de tri de données (18) étant configuré pour trier les données du groupe de données sur la base des caractéristiques d'un modèle de prédiction de défaillance à générer ;
c) un module de génération de modèle de prédiction (16), le module de génération de modèle de prédiction (16) étant configuré pour construire le modèle de prédiction de défaillance pour prédire la défaillance d'un véhicule à partir des données triées par le module de tri de données (18) ; et
d) un module de prédiction de défaillance (17), le module de prédiction de défaillance (17) étant configuré pour prédire, dans la situation où le modèle de prédiction de défaillance est appelé et sur la base des données en temps réel du véhicule, s'il y a une défaillance imminente au niveau du véhicule, et pour émettre une alerte lorsqu'il est prédit une défaillance imminente au niveau du véhicule.

2. Système d'alerte de défaillance de véhicule (2) selon la revendication 1, **caractérisé en ce que** :
le modèle de prédiction de défaillance construit est un premier type de modèle et/ou un second type de modèle, le premier type de modèle étant un modèle de prédiction de défaillance construit sur la base de données de véhicules sains et utilisé pour décrire l'état de fonctionnement des véhicules sains, tandis que le second type de modèle est un modèle de prédiction de défaillance construit sur la base de données de véhicules dans lesquels une défaillance est imminente et qui est utilisé pour décrire l'état de fonctionnement des véhicules dans lesquels une défaillance est imminente.

3. Système d'avertissement de défaillance de véhicule (2) selon la revendication 1 ou la revendication 2, **caractérisé en ce que** :

le modèle de prédiction de défaillance est exprimé sous la forme d'une fonction mathématique entre un paramètre de défaillance spécifique et au moins un paramètre d'influence pour le paramètre de défaillance, le paramètre de défaillance spécifique faisant référence à un paramètre caractérisant une défaillance spécifique du véhicule ; et/ou
le module de génération de modèle de prédiction (16) est configuré pour construire le modèle de prédiction de défaillance à partir des données triées à l'aide d'un algorithme de traitement de données massives.

4. Système d'alerte de défaillance de véhicule (2) selon la revendication 3, **caractérisé en ce que** :
le module de prédiction de défaillance (17) est en outre configuré pour : substituer, lors de la prédiction de l'imminence d'une défaillance dans le véhicule, une valeur de mesure en temps réel de l'au moins un paramètre d'influence dans la fonction mathématique de manière à calculer une valeur estimée du paramètre de défaillance ; et déterminer s'il existe une défaillance imminente dans le véhicule courant en comparant la valeur estimée du paramètre de défaillance avec la valeur de mesure en temps réel correspondant au paramètre de défaillance.

5. Système d'alerte de défaillance de véhicule (2) selon la revendication 4, **caractérisé en ce que** :
le module de prédiction de défaillance (17) est en outre configuré pour : dans la situation où le premier type de modèle est appelé, si un écart entre la valeur estimée du paramètre de défaillance et la valeur de mesure en temps réel correspondant au paramètre de défaillance dépasse une plage prédéfinie, indiquer que la défaillance **caractérisée par** le paramètre de défaillance est imminente dans le véhicule ; et, dans la situation où le second type de modèle est appelé, si l'écart entre la valeur estimée du paramètre de défaillance et la valeur de mesure en temps réel correspondant au paramètre de défaillance se situe dans la plage prédéfinie, indiquer que la défaillance **caractérisée par** le paramètre de défaillance est imminente dans le véhicule.

6. Procédé d'avertissement de défaillance de véhicule, le procédé comprenant les étapes suivantes :

a) collecter (S1 ; S11) des données de véhicule en provenance d'une pluralité de véhicules (3-1, 3-2...3-n) dans un laps de temps donné pour former un groupe de données ; le procédé étant en outre **caractérisé par** es étapes suivantes :
b) trier (S3 ; S12) des données du groupe de données sur la base des caractéristiques d'un modèle de prédiction de défaillance à générer ;
c) construire (S4), à partir des données triées, le modèle de prédiction de défaillance pour prédire la défaillance d'un véhicule ;

d) prédire (S6), sur la base du modèle de prédiction de défaillance et des données en temps réel du véhicule, si la survenue d'une défaillance est imminente dans un véhicule ; et

e) émettre (S7) une alerte en cas de prédiction de la survenue imminente d'une défaillance dans le véhicule.

7. Procédé d'avertissement de défaillance de véhicule selon la revendication 6, **caractérisé en ce que** les étapes b) et c) sont mises en oeuvre :

à l'étape b), en triant les données de véhicules sains à partir du groupe de données, puis, à l'étape c), en construisant un premier type de modèle pour décrire l'état de fonctionnement des véhicules sains ; et/ou

à l'étape b), en triant, dans l'ensemble de données, les données des véhicules pour lesquels une défaillance est imminente puis, à l'étape c), en construisant un second type de modèle pour décrire l'état de fonctionnement des véhicules pour lesquels une défaillance est imminente.

8. Procédé d'avertissement de défaillance de véhicule selon la revendication 6 ou la revendication 7, **caractérisé en ce que** l'étape c) est mise en oeuvre :
en exprimant le modèle de prédiction de défaillance sous la forme d'une fonction mathématique entre un paramètre de défaillance spécifique et au moins un paramètre d'influence pour le paramètre de défaillance, le paramètre de défaillance spécifique faisant référence à un paramètre caractérisant une défaillance de véhicule spécifique ; et/ou en construisant le modèle de prédiction de défaillance à partir des données triées à l'aide d'un algorithme de traitement de données massives.

9. Procédé d'alerte de défaillance de véhicule selon la revendication 8, **caractérisé en ce que** l'étape d) est mise en oeuvre :

en substituant une valeur de mesure en temps réel de l'au moins un paramètre d'influence dans la fonction mathématique de manière à calculer une valeur estimée du paramètre de défaillance, et en comparant la valeur estimée du paramètre de défaillance à la valeur de mesure en temps réel correspondant au paramètre de défaillance ;

et, dans la situation dans laquelle le premier type de modèle est utilisé, si un écart entre la valeur estimée du paramètre de défaillance et la valeur de mesure en temps réel correspondant au paramètre de défaillance dépasse une plage prédéfinie, en indiquant que la défaillance **caractérisée par** le paramètre de défaillance est imminente dans le véhicule ; et, dans la situation où le second type de modèle est utilisé, si l'écart entre la valeur estimée du paramètre de défaillance et la valeur de mesure en temps réel correspondant au paramètre de défaillance se situe dans la plage prédéfinie, en indiquant que la défaillance **caractérisée par** le paramètre de défaillance est imminente dans le véhicule.

10. Procédé d'avertissement de défaillance de véhicule selon l'une quelconque des revendications 6 à 9, **caractérisé en ce que** l'étape suivante est en outre exécutée après l'étape c) et avant l'étape d) :
vérifier le modèle de prédiction de défaillance à l'aide des données du véhicule non utilisées dans la construction du modèle de prédiction de défaillance, et ajuster le modèle de prédiction de défaillance dans le cas où la vérification ne satisfait pas les exigences.

*Fig. 1*

*Fig. 2*

15

18

16

2

17

*Fig. 3*

S1

S2

S3

S4

S5

S6

S7

*Fig. 4*

S11

S12

S13

S14

S15

S16

S17

Fig. 5

S21

S22

S23

S24

S25

S26

S27

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160035150 A1
- US 2007271014 A1
- US 2016232466 A1